# EUROPEAN PATENT SPECIFICATION

(11) **EP 3 869 213 B1**
(45) Date of publication and mention of the grant of the patent: **06.09.2023**
(21) Application number: 21156312.7
(22) Date of filing: 10.02.2021
(51) Int. Cl.: G01R 31/54, H02H 3/253

(54) **OPEN PHASE AND INTERRUPTION DETECTION DEVICE FOR THREE-PHASE AC POWER SUPPLY**
VORRICHTUNG ZUR ERKENNUNG VON OFFENEN PHASEN UND UNTERBRECHUNGEN IN EINER DREIPHASIGEN WECHSELSTROMVERSORGUNG
DISPOSITIF DE DÉTECTION DE PHASE OUVERTE ET D'INTERRUPTION POUR UNE ALIMENTATION CA TRIPHASÉE

(30) Priority: 21.02.2020 JP 2020027707
(43) Date of publication of application: 25.08.2021
(73) Proprietor: Panasonic Intellectual Property Management Co., Ltd., Osaka-shi, Osaka 540-6207 (JP)
(72) Inventor: KAI, Koushin, Osaka, 540-6207 (JP); SHIMIZU, Kiminori, Osaka, 540-6207 (JP); SUZUKI, Ken'ichi, Osaka, 540-6207 (JP); IMADA, Yusuke, Osaka, 540-6207 (JP); SAEGUSA, Fumitake, Osaka, 540-6207 (JP)
(74) Representative: SSM Sandmair

(56) References cited:
- DE-A1- 3 320 013
- JP-B2- 3 718 597
- JP-B2- 4 172 634
- US-A- 3 999 087

## Description

### BACKGROUND

### 1. Technical Field

The present disclosure relates to an open phase and interruption detection device for a three-phase AC power supply.

### 2. Description of the Related Art

Conventionally, a method for detecting an open phase and interruption of a three-phase AC power supply has been known.

For example, in Unexamined Japanese Patent Application No. 2008-187874 (PTL 1), photocouplers are connected between respective lines of a first phase and a second phase, the second phase and a third phase, and the third phase and the first phase of the three-phase AC power supply. A light emitting element of this photocoupler emits light when a normal voltage is supplied. On the other hand, when the light receiving element of the photocoupler is turned on, a pulse detection signal is output. Accordingly, open phase of each phase is detected based on presence or absence of this pulse detection signal (at a normal time, there are pulses, and at a time of open phase, there are no pulses).

For example, in Unexamined Japanese Patent Application No. 2012-42316 (PTL 2), two phases of a three-phase AC power supply are connected to an electromagnetic contactor (in the example, R phase and T phase). Consequently, by detecting presence or absence of excitation of a coil of the electromagnetic contactor, it is possible to detect an open phase of any one of the two connected phases of the electromagnetic contactor. Further, two phases different from the electromagnetic contactor (in the example, R phase and S phase) are connected to the single-phase open phase detection circuit. The light receiving element of the photocoupler in the single-phase open phase detection circuit outputs the pulse detection signal when it is turned on. With this configuration, the open phase of any of the two phases can be detected by detecting presence or absence of the pulse detection signal. As described above, PTL 2 discloses a method for detecting which phase is open phase by combining open phase results obtained by the electromagnetic contactor and the single-phase open phase detection circuit.

In PTL 1, in order to turn on the light receiving element of the photocoupler of only the phase that is open phase according to the power supply voltage, adjusting a resistance value and a threshold of the photocoupler, and the like are necessary, and it takes time and effort to adjust the circuit element according to the power supply voltage.

In PTL 2, interruption is detected by using a DC voltage after rectifying the three-phase AC power supply by a rectifier circuit. However, a smoothing capacitor is connected in parallel to the rectifier circuit and the interruption cannot be detected until the voltage of this capacitor becomes zero, and thus a detection response is delayed.

JP 3 718597 B2 describes an open-phase detection circuit by which an open phase can be detected surely even when a bypass circuit exists in the input of an electric apparatus. Current supply passages to a photocoupler PC1, a photocoupler PC2 and a photocoupler PC3 are firmed via a diode D1, a diode D2 and a diode D3 from a three-phase power-supply line R, a three-phase power-supply line S and a three-phase power-supply line T. Return current passages which reach the power-supply lines R, S, T from the respective photocouplers PC1, PC2, PC3 are formed via a common resistor, a diode D4, a diode D5 and a diode D6. Thereby, even when a bypass circuit by an impedance exists, an open phase can be detected surely.

US 3 999 087 A describes a circuit for detection of a missing phase voltage condition, and certain other malfunction conditions, in the output of a three-phase A.C. alternator or power supply. Three pulse forming circuits are provided with their input ends each connected to receive a different one of the phase voltages. Each pulse forming circuit provides an output pulse signal for a duration corresponding to the excursion of its corresponding phase signal in a predetermined one of the voltage polarities of the power supply. The outputs of the pulse forming circuits are connected to individual inputs of an OR gate circuit. The OR circuit is adapted to clamp the trigger input of a retriggerable monostable multivibrator to ground during presence of a pulse output from any of the pulse forming circuits. The duration of a triggered output state of the multivibrator is chosen to be greater than the period of alternation of the phase voltages. A construction may be provided in which the pulse forming circuits and the input channels of the OR gate network are formed of opto-isolator units to achieve electrical isolation of the input and the output stages.

JP 4 172634 B2 describes a miniaturizable three-phase three-line type circuit breaker with open-phase protection. In the case where any of three-phase three-line cable runs is not in an open phase, when current is carried to rectifying diodes, light emitting diodes of photocouplers and resistors connected between respective phases by power lines, the divided voltages of voltage-dividing resistors inputted to terminals of an integrated circuit never exceed a threshold value of an open-phase determination reference previously set by turning on of transistors of the photocouplers, so that a trip coil is not driven and the cable runs are not cut off. When one phase of the cable runs is opened, two out of the photocouplers are turned off, and a voltage exceeding the threshold value is applied to the terminals of the integrated circuit in the meantime. Then, the integrated circuit charges a capacitor; the capacitor turns on a thyristor when the capacitor is charged to a predetermined value; and the trip coil is driven to open a switching contact.

### SUMMARY OF THE INVENTION

The invention is defined by the subject-matter of the independent claims. The dependent claims are directed to advantageous embodiments.

### ADVANTAGES OF THE INVENTION

Advantageously, there is provided a detection device capable of reducing labor and time due to work such as adjusting a circuit element according to a power supply voltage, or detecting an open phase or interruption of a three-phase AC power supply in a short time.

An open phase and interruption detection device for a three-phase AC power supply according to one aspect of the present disclosure includes three photocouplers that are connected between respective lines of an L1 phase and an L2 phase, the L2 phase and an L3 phase, and the L3 phase and the L1 phase, respectively, of the three-phase AC power supply, each include a light receiving element that turns on at a predetermined threshold voltage or higher, and convert line voltages of the L1 phase and the L2 phase, the L2 phase and the L3 phase, and the L3 phase and the L1 phase of the three-phase AC power supply into three detection signals, and a controller that acquires three pulse detection signals from the three detection signals output from the three photocouplers or an inverted pulse detection signal obtained by inverting the three pulse detection signals, in which the controller performs an AND operation of the three pulse detection signals or inverts three inverted pulse detection signals and performs the AND operation, to generate an AND operation pulse, and determines a normal state and presence or absence of an open phase or interruption by the AND operation pulse.

Further, when the controller determines the presence of the open phase, the controller may determine which of the L1 phase, the L2 phase, and the L3 phase is the open phase based on one of the three pulse detection signals or the three inverted pulse detection signals and the AND operation pulse.

Further, the controller includes first and second counters, in which the controller may (a) change the first counter sequentially in a constant direction during a time in which a value of the AND operation pulse continues to be 0, and determine that it is a normal state when the first counter exceeds a first value that is set in advance, and (b) return the first counter to 0 when the value of the AND operation pulse is switched from 0 to 1 and sequentially changes the second counter in a constant direction during a time in which the AND operation pulse continues to be 1, and determine the presence of the interruption when it is determined that the second counter is equal to or exceeds a second value that is set in advance, or determine the presence of the open phase when it is determined that the second counter is equal to or exceeds a third value smaller than the first and second values.

Further, when the value of the AND operation pulse is 0 when determining the open phase, the controller may determine that the phase for which a value out of the three pulse detection signals is 1 or the phase for which a value out of the three inverted pulse detection signals is 0 as the open phase.

Further, the controller may adjust at least one of the first to third values according to at least one of the voltage and frequency of the three-phase AC power supply.

Further, a method for detecting an open phase and interruption in a three-phase AC power supply according to one aspect of the present disclosure includes acquiring three pulse detection signals or three inverted pulse detection signals of three pulse detection signals from three photocouplers connected to respective lines between lines of an L1 phase and an L2 phase, between lines of the L2 phase and an L3 phase, and between lines of the L3 phase and the L1 phase of the three-phase AC power supply that outputs an alternating current (AC) voltage in the L1 phase, the L2 phase, and the L3 phase, performing an AND operation of the three pulse detection signals, or inverting the three inverted pulse detection signals and performing the AND operation, to generate an AND operation pulse, and determining a normal state of the AC voltage and presence or absence of an open phase or interruption by the AND operation pulse.

Further, when the presence of the open phase of the AC voltage is determined, which of the L1 phase, the L2 phase, and the L3 phase is the open phase may be determined based on each of the pulse detection signals or each of the inverted pulse detection signals and the AND operation pulse.

In addition, the determining of the presence or absence of the open phase or interruption may include (a) changing a first counter sequentially in a constant direction during a time in which a value of the AND operation pulse continues to be 0, and determining that it is normal when it is determined that the first counter is equal to or exceeds a first value that is set in advance, and (b) returning the first counter to 0 when the AND operation pulse is switched from 0 to 1 and sequentially changing the second counter in a constant direction during a time in which the value of the AND operation pulse continues to be 1, and determining the presence of the interruption when the second counter is equal to or exceeds a second value that is set in advance, or determining the presence of the open phase when it is determined that the second counter is equal to or exceeds a third value smaller than the first and second values.

Further, the determination of the open phase may execute before the determination of the interruption.

Further, the determination of the interruption may be executed before the determination of the open phase.

Further, when the AND operation pulse is 0 in the determination of the open phase, the phase for which a value out of the three pulse detection signals is 1 or the phase for which a value out of the three inverted pulse detection signals is 0 may be determined as the open phase.

Further, at least one of the first to third values may be set in a controller, and at least one of the first to third values that are set may be adjusted according to at least one of the voltage or frequency of the three-phase AC power supply.

In the open phase and interruption detection device for the three-phase AC power supply according to one aspect of the present disclosure, a time for adjusting the circuit element according to the power supply voltage or a time for detecting an open-phase or interruption of the three-phase AC power supply can be reduced.

### BRIEF DESCRIPTION OF DRAWINGS

FIG. 1 is a block diagram illustrating a configuration of an open phase and interruption detection device for a three-phase AC power supply according to a first exemplary embodiment;
FIG. 2 is a schematic diagram of a detection circuit of the detection device;
FIG. 3 is a schematic diagram of the detection circuit when L3 is open phase;
FIG. 4 is a waveform diagram describing an operation at a normal time related to the detection device;
FIG. 5 is a waveform diagram describing an operation at a time of open phase related to the detection device;
FIG. 6 is a waveform diagram describing an operation at a time of interruption related to the detection device;
FIG. 7 is a waveform diagram describing a method for determining an open phase;
FIG. 8 is a waveform diagram describing a method for determining interruption;
FIG. 9 is a waveform diagram describing a method for determining an open phase and interruption;
FIG. 10 is a flowchart illustrating a method for determining an open phase and interruption;
FIG. 11 is a flowchart illustrating a method for determining an open phase related to a detection device for an open phase and interruption of a three-phase AC power supply according to a second exemplary embodiment; and
FIG. 12 is a summary diagram of a determination method in step S60.

### DETAILED DESCRIPTION

### (Background of obtaining one aspect of present disclosure)

As described above, in a case of determining an open phase and interruption of the three-phase AC power supply in accordance with the disclosure of PTL 1, it is necessary to change the circuit element according to the power supply voltage. In a case of determining an open phase and interruption of the three-phase AC power supply according to the disclosure of PTL 2, the interruption cannot be detected until the voltage of the smoothing capacitor connected in parallel to the rectifier circuit becomes zero, and thus a detection response is delayed.

The present inventors have enthusiastically dedicated studies and experiments to solve these problems.

Similarly to PTL 1, the inventors connected photocouplers between respective lines of an L1 phase and an L2 phase, the L2 phase and an L3 phase, and the L3 phase and the L1 phase, respectively, of the three-phase AC power supply. The photocouplers convert respective line voltages of the L1 phase and the L2 phase, the L2 phase and the L3 phase, and the L3 phase and the L1 phase of the three-phase AC power supply into pulse detection signals, respectively. The light receiving element of each photocoupler is configured to turn on at a predetermined threshold voltage or higher. Moreover, a controller acquires a detection signal output from the photocoupler as a pulse detection signal. Alternatively, the controller generates a pulse detection signal based on the detection signal output from the photocoupler.

Accordingly, the inventors enthusiastically repeated studies and experiments, and have found that the open phase and interruption can be detected by the following open phase and interruption detection device for the three-phase AC power supply. That is, the controller performs an AND operation on each pulse detection signal and generates an AND operation pulse. With such a configuration, the controller can determine presence or absence of the open phase or interruption based on each pulse detection signal and the AND operation pulse. Moreover, it has been found that when the controller determines presence of an open phase, the controller can determine which of L1 phase, L2 phase, and L3 phase has become the open phase.

Hereinafter, a specific example of the open phase and interruption detection device for the three-phase AC power supply according to one aspect of the present disclosure will be described with reference to the drawings. Note that all of the exemplary embodiments described below are comprehensive or specific examples. Numerical values, components, arranged positions and connection forms of the components, and the like to be presented in the following exemplary embodiments are illustrative and are not to limit the present disclosure. Further, among those components introduced in the following exemplary embodiments, components that are not described in the independent claim(s) representing the highest concept are illustrated herein as optional components.

Note that each figure is a schematic view and is not necessarily exactly illustrated. Further, in each figure, substantially the same configurations are designated by the same reference numerals, and duplicate description may be omitted or simplified.

### (First exemplary embodiment)

Hereinafter, the open phase and interruption detection device for the three-phase AC power supply according to the first exemplary embodiment will be described with reference to the drawings.

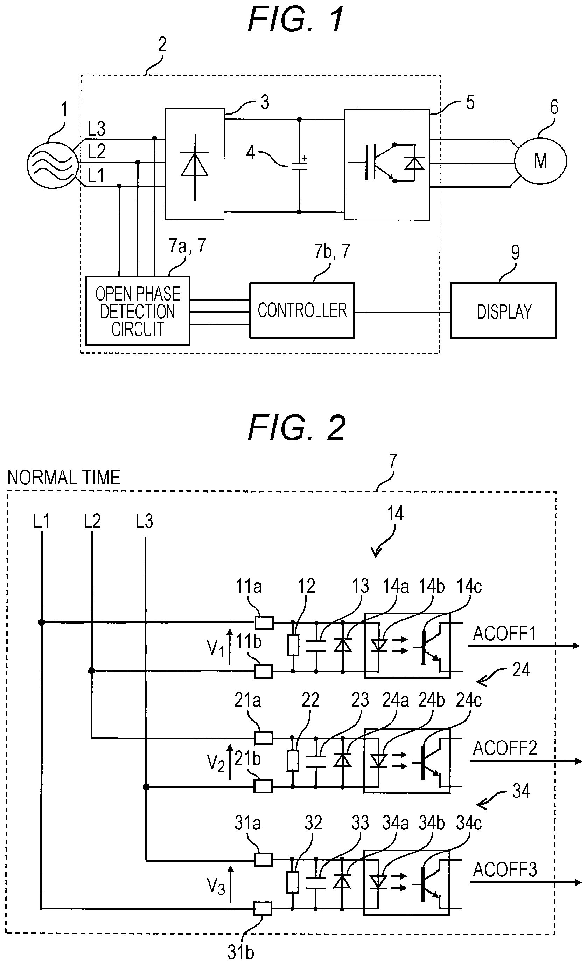

FIG. 1 is a block diagram illustrating a configuration of the open phase and interruption detection device for the three-phase AC power supply according to the first exemplary embodiment.

In FIG. 1, three-phase AC power supply 1 is connected to motor 6 via inverter 2. Three-phase AC power supply 1 is also directly connected to open phase detection circuit 7a. Three-phase AC power supply 1 outputs an AC voltage in each of a first phase (L1 phase), a second phase (L2 phase), and a third phase (L3 phase) each having a phase difference of 2/3π.

Inverter device 2 includes rectifier circuit (forward converter) 3, smoothing capacitor 4, reverse conversion circuit 5, and open phase and interruption detection device 7 for the three-phase AC power supply. Inverter device 2 is supplied with power from three-phase AC power supply 1 to supply AC power with a variable voltage and variable frequency to motor 6.

Open phase and interruption detection device 7 includes detection circuit 7a and controller 7b. Detection circuit 7a detects respective voltages between the L1 phase and the L2 phase, between the L2 phase and the L3 phase, and between the L3 phase and the L1 phase of three-phase AC power supply 1, and outputs open phase detection signals corresponding to the respective phases. The outputs of detection circuit 7a are supplied to controller 7b. Controller 7b determines an open phase or interruption based on the outputs of detection circuit 7a, and sends a result to display unit 9.

FIG. 2 is a schematic diagram of detection circuit 7a of the open phase and interruption detection device for the three-phase AC power supply according to the first exemplary embodiment.

As illustrated in FIG. 2, resistors 11a, 11b for limiting current are connected to the L1 phase, the L2 phase, respectively, between lines of the L1 phase and the L2 phase of three-phase AC power supply 1. Bias resistor 12, capacitor 13, diode 14a, and photocoupler 14 are connected between the lines of the L1 phase and L2 phase. Photocoupler 14 has light emitting element 14b and light receiving element 14c. That is, bias resistor 12, capacitor 13, diode 14a, and light emitting element 14b are connected in parallel between the lines of the L1 phase and L2 phase. On the other hand, resistors 11a, 11b and bias resistor 12 are connected in series.

Resistors 21a, 21b for limiting current are connected to the L2 phase and the L3 phase, respectively, between the L2 phase and the L3 phase similarly to the L1 phase and the L2 phase. Bias resistor 22, capacitor 23, diode 24a, and photocoupler 24 are connected between lines of the L2 phase and the L3 phase. Photocoupler 24 includes light emitting element 24b and light receiving element 24c. That is, bias resistor 22, capacitor 23, diode 24a, and light emitting element 24b are connected in parallel between the L2 phase and L3 phase lines. On the other hand, resistors 21a, 21b and bias resistor 22 are connected in series.

Moreover, resistors 31a, 31b for limiting current are connected to the L3 phase and the L1 phase, respectively, between the lines of the L3 phase and the L1 phase similarly to the L1 phase and the L2 phase. Bias resistor 32, capacitor 33, diode 34a, and photocoupler 34 are connected between the lines of the L3 phase and the L1 phase. Photocoupler 34 includes light emitting element 34b and light receiving element 34c. That is, bias resistor 32, capacitor 33, diode 34a, and light emitting element 34b are connected in parallel between the lines of the L3 phase and the L1 phase. On the other hand, resistors 31a, 31b and bias resistor 32 are connected in series.

Photocouplers 14, 24, 34 are turned on and off according to voltage V1 between the L1 phase and the L2 phase, voltage V2 between the L2 phase and the L3 phase, and voltage V3 between the L3 phase and the L1 phase, respectively. That is, photocouplers 14, 24, 34 are turned on when voltages V1, V2, V3 are larger than a value of threshold voltage V_ON, respectively. On the other hand, photocouplers 14, 24, 34 are turned off when voltages V1, V2, V3 are smaller than the value of threshold voltage V_ON, respectively.

Photocouplers 14, 24, 34 output detection signals by turning them on and off. Photocoupler 14 generates a pulse detection signal (ACOFF1) as a detection signal. Photocoupler 24 generates a pulse detection signal (ACOFF2) as a detection signal. Photocoupler 34 generates a pulse detection signal (ACOFF3) as a detection signal. Controller 7b acquires these three pulse detection signals, and determines normal, open-phase, and interruption based on these three pulse detection signals.

Although not illustrated in FIG. 2, pull-up resistors are connected to light receiving elements 14c, 24c, 34c of photocouplers 14, 24, 34, respectively. Photocouplers 14, 24, 34 output high detection signals when being off and maintain a low state when being on.

Note that each of photocouplers 14, 24, 34 illustrated in FIG. 2 is turned on only when a current flows in one direction, but may be turned on for a current from both directions.

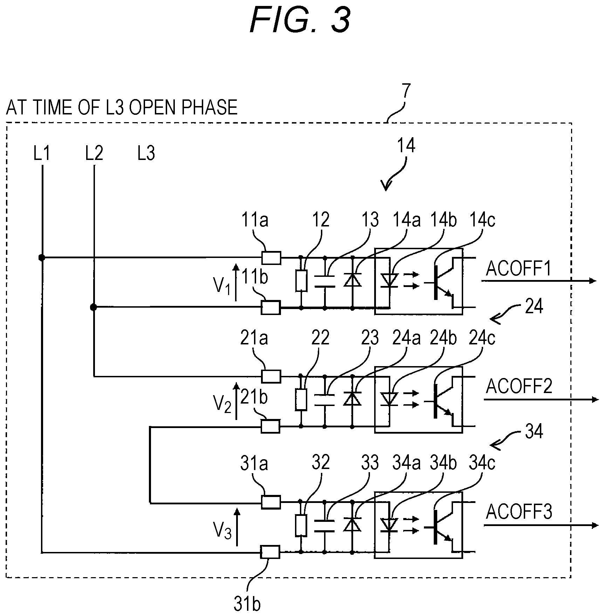

FIG. 3 is a schematic diagram of open phase detection circuit 7a when L3 is open-phase.

Next, interphase voltages V1 to V3 at a normal time when the open phase and interruption have not occurred in three-phase AC power supply 1, at a time of the open phase of three-phase AC power supply 1, and at a time of the interruption of three-phase AC power supply 1 will be described. Note that V1 is a voltage between the L1 phase and the L2 phase, V2 is a voltage between the L2 phase and the L3 phase, and V3 is a voltage between the L3 phase and the L1 phase. In the following description, an open phase of the L3 phase has occurred in three-phase AC power supply 1, and in interruption of three-phase AC power supply 1, two or more of the three phases are open-phase. The resistance values of resistors 11a, 11b, 21a, 21b, 31a, 31b are the same.

Normal interphase voltages of three-phase AC power supply 1 are V0 = effective value voltage × √2, V1= V0sin(ωt), V2 = V0sin(ωt + 2π/3), V3 = V0sin(ωt + 4π/3).

In a state where the L3 phase is open-phase, the interphase voltages of three-phase AC power supply 1 are V0 = effective value voltage × √2, V1 = V0sin(ωt), V2 = -V1/2, V3 = -V1/2.

In a state where three-phase AC power supply 1 is interrupted, the interphase voltages of three-phase AC power supply 1 are V0 = effective value voltage × √2, V1 = 0, V2 = 0, V3 = 0.

In a state where three-phase AC power supply 1 is operating normally, the phase of V2 advances by (2/3)π with respect to V1 and the phase of V3 advances (4/3)π with respect to V1.

At a time of L3 open phase, V2 and V3 are divided based on V1. However, V2 and V3 are in opposite phase to V1. Note that if the resistance values of resistors 11a, 11b, 21a, 21b, 31a, 31b are the same, V2 and V3 have half the voltage of V1.

There is no closed circuit at the time of interruption, and thus V1, V2, V3 are 0.

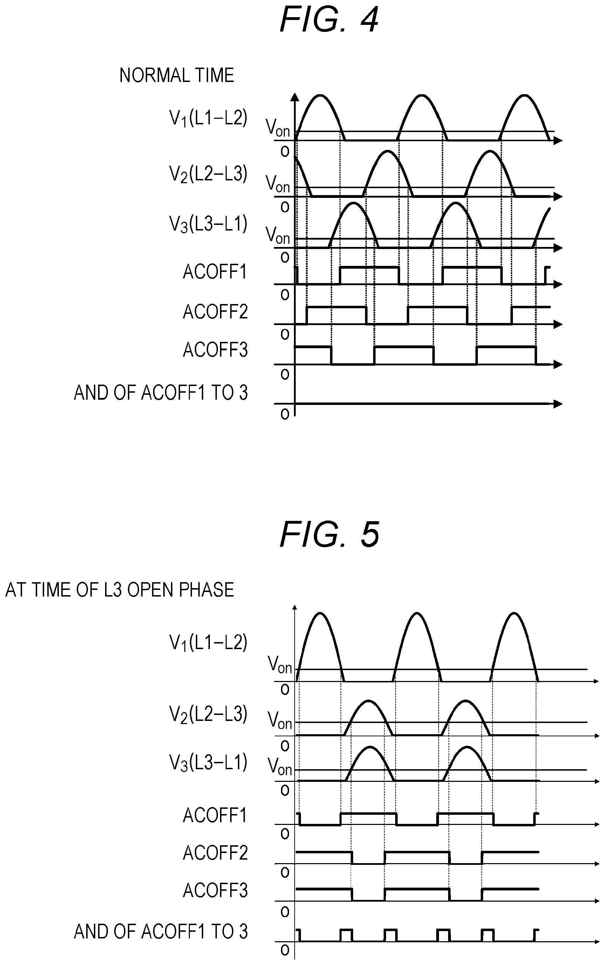

FIG. 4 is a waveform diagram describing an operation at a normal time related to open phase and interruption detection device 7 according to the first exemplary embodiment. V1, V2, V3 are waveforms of the voltages of respective phases when three-phase AC power supply 1 is operating normally. Voltage V_ON is a threshold voltage at which photocouplers 14, 24, 34 are turned on. Detection signals of photocouplers 14, 24, 34 become low when V1, V2, V3 exceed voltage V_ON, and become high when V1, V2, V3 fall below voltage V_ON, respectively. Note that controller 7b processes binary values of 1 and 0 by digital calculation. Accordingly, controller 7b processes a high state as a pulse detection signal of 1 and a low state as a pulse detection signal of 0. Controller 7b illustrated in FIG. 1 performs an AND operation on ACCOFF1 to ACCOFF3 to obtain an AND operation pulse waveform. As illustrated in FIG. 4, a value of the AND operation pulse at a normal time is 0 and constant. Accordingly, when controller 7b detects that the value of the AND operation pulse is maintained at 0 for a predetermined time or longer while monitoring the AND operation pulse, it can be determined that three-phase AC power supply 1 is operating normally. Accordingly, normal determination time T_J is set in controller 7b. When controller 7b determines that the value of the AND operation pulse is maintained at 0 for a time longer than normal determination time T_J, it is determined that three-phase AC power supply 1 is operating normally. As will be described later, the AND operation pulse repeats 1 and 0 at the time of open phase. Accordingly, normal determination time T_J is longer than the time for the AND operation pulse to maintain 0 at the time of open phase. Note that voltages V1, V2, V3 may be full waves instead of half waves.

FIG. 5 is a waveform diagram describing an operation at the time of open phase related to the open phase and interruption detection device 7. FIG. 5 illustrates a relationship between the waveforms of voltages V1, V2, V3, the pulse waveforms of threshold voltage V_ON and ACCOFF1 to 3, and the AND operation pulse waveform at the time of open phase of L3 illustrated in FIG. 3. As illustrated in FIG. 5, the AND operation pulse repeats 0 and 1 in the open phase state. Accordingly, when controller 7b detects that the value of the AND operation pulse is maintained at 0 for a predetermined time or longer while monitoring the AND operation pulse, it can be determined that three-phase AC power supply 1 is operating normally. Accordingly, open phase determination time T_PL is set in controller 7b. When controller 7b determines that the value of the AND operation pulse is maintained at 1 for a time longer than open phase determination time T_PL, it is determined that any of the L1 phase, the L2 phase, and the L3 phase is open-phase.

Note that controller 7b may determine presence of an open phase based on the time during which the value of the AND operation pulse is maintained at 0. In this case, controller 7b determines that three-phase AC power supply 1 has an open phase when it is determined that the value of the AND operation pulse is maintained at 0 for a time longer than open phase determination time T_PL. In this case, open phase determination time T_PL is set to be equal to or less than normal determination time T_J. Alternatively, controller 7b can use normal determination time T_J instead of open phase determination time T_PL. In this case, controller 7b determines an open phase when the time during which the value of the AND operation pulse is maintained at 0 exceeds 0 and is shorter than normal determination time T_J.

The AND operation pulse waveform is also the same as the time of open phase of the L3 phase, even in a state where the L1 phase or the L2 phase is open-phase. However, ACOFF1 to 3 in a state where the L1 phase or the L2 phase is open-phase is different from ACOFF1 to 3 in a state where the L3 phase is open-phase. Therefore, controller 7b can determine which of the L1 phase, the L2 phase, and the L3 phase is open-phase by detecting the states of ACOFF 1 to 3.

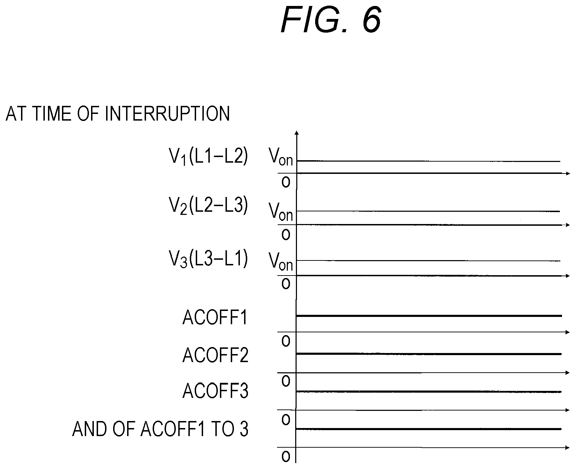

FIG. 6 is a waveform diagram describing an operation at the time of interruption related to open phase and interruption detection device 7. FIG. 6 illustrates a relationship between the waveforms of voltages V1, V2, V3, the pulse waveforms of threshold voltage V_ON and ACCOFF1 to 3, and the AND operation pulse waveform at the time of interruption. As illustrated in FIG. 6, the value of the AND operation pulse is maintained at 1 in an interrupted state. Therefore, when controller 7b monitors the AND operation pulse and detects that the value of the AND operation pulse is maintained at 1 for a predetermined time or longer, controller 7b can determine that three-phase AC power supply 1 is interrupted. Accordingly, interruption determination time T_PF is set in controller 7b. When controller 7b determines that the value of the AND operation pulse is maintained at 1 for a time longer than interruption determination time T_PF, controller 7b determines presence of the interruption. Note that interruption determination time T_PF is longer than the time during which the AND operation pulse is maintained at 1 when the phase is open-phase. Accordingly, interruption determination time T_PF is longer than open phase determination time T_PL.

Here, how to determine a value of threshold voltage V_ON will be described. As illustrated in FIGS. 4 to 6, the pulse waveforms of ACCOFF1 to 3 and the time during which the AND operation pulse waveform maintains the value of 1 change depending on the value of V_ON. At the time of open phase, the voltages are divided as described above. Accordingly, the value of V_ON is set to half or less of a maximum value of the three-phase AC power supply voltage. Thus, the waveform of the AND operation pulse is always 0 at a normal time as illustrated in FIG. 4, repeats 1 and 0 as illustrated in FIG. 5 at the time of open phase, and is always 1 as illustrated in FIG. 6 at the time of interruption.

Note that the larger the value of V_ON, the longer the duration of 1 in the pulse waveforms of ACCOFF1 to 3 and the AND operation pulse waveform. That is, the smaller the value of V_ON, the shorter the duration of 1 in the pulse waveforms of ACCOFF1 to 3 and the waveform of the AND operation pulse.

As illustrated in FIGS. 4 to 6, the waveform of the AND operation pulse is different among the normal time, the time of open phase, and the time of interruption. Therefore, controller 7b can determine an open phase and interruption of three-phase AC power supply 1 by the AND operation pulse. Further, controller 7b can determine which phase of three-phase AC power supply 1 is open-phase by detecting each of the waveforms of ACOFF1 to 3. That is, ACOFF 1 to 3 are detected by controller 7b, and normal, open phase, and interruption is possible by the AND operation pulse calculated from their values. Thus, normal, open phase, and interruption can be determined easily without changing circuit elements as in the conventional case. Further, because controller 7b needs the voltage of smoothing capacitor 4 to generate the AND operation pulse, it is possible to suppress a delay in the response until the AND operation pulse is generated. Therefore, controller 7b can detect the open phase or the interruption of three-phase AC power supply 1 in a short time. By setting threshold voltage V_ON to a desired value, the AND operation pulse is output in both the open phase and the interruption states. Therefore, controller 7b can reliably determine the open phase or interruption.

In order to generate ACOFF 1 to 3 in open phase detection circuit 7a, the value of threshold voltage V_ON may be adjusted by the above-described method. Therefore, the same circuit can be used for the circuit that generates ACOFF 1 (11a to 14c), the circuit that generates ACOFF2 (21a to 24c), and the circuit that generates ACOFF3 (31a to 34c).

Next, determination of open phase and interruption of three-phase AC power supply 1 in controller 7b will be specifically described.

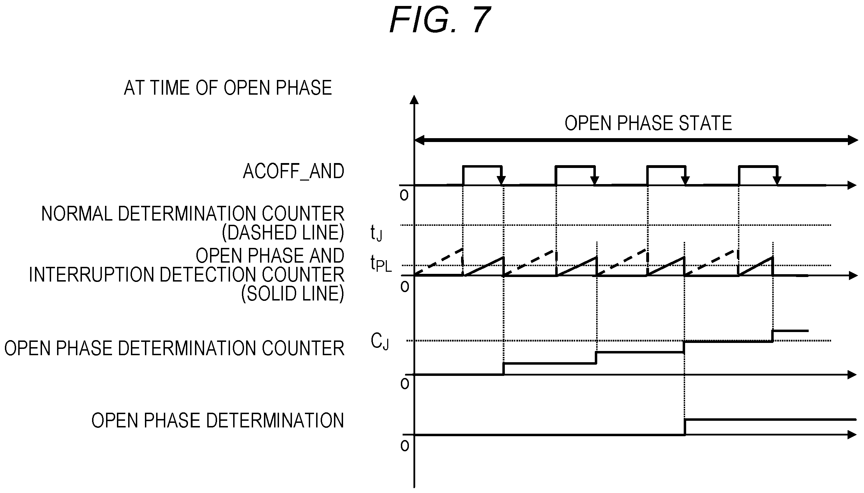

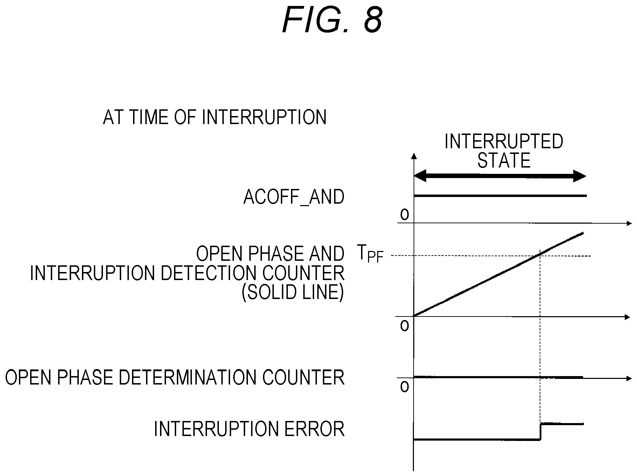

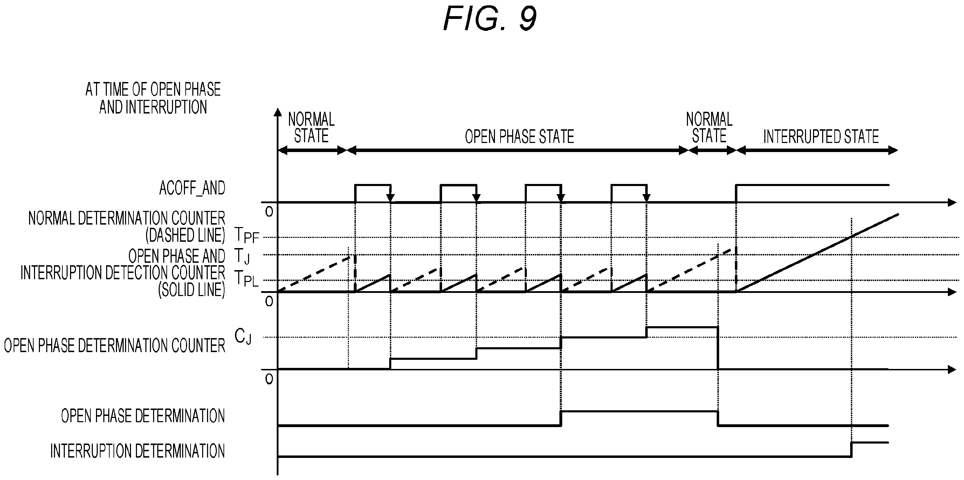

FIG. 7 is a waveform diagram describing a method for determining an open phase. FIG. 8 is a waveform diagram describing a method for determining interruption. FIG. 9 is a waveform diagram describing a method for determining open phase and interruption.

FIG. 7 illustrates a relationship among the AND operation pulse waveform (ACCOFF_AND), an open phase and interruption detection counter, an open phase determination counter, normal determination time T_J, open phase determination time T_PL, and an open phase determination result.

FIG. 8 illustrates a relationship among ACCOFF_AND, the open phase and interruption detection counter, the open phase determination counter, interruption determination time T_PF, and an interruption determination result.

FIG. 9 illustrates a relationship among ACCOFF_AND, the normal determination counter, the open phase and interruption detection counter, the open phase determination counter, interruption determination time T_PF, normal determination time T_J, open phase determination time T_PL, an open phase determination result, and an interruption determination result.

Open phase determination time T_PL is shorter than interruption determination time T_PF and normal determination time T_J.

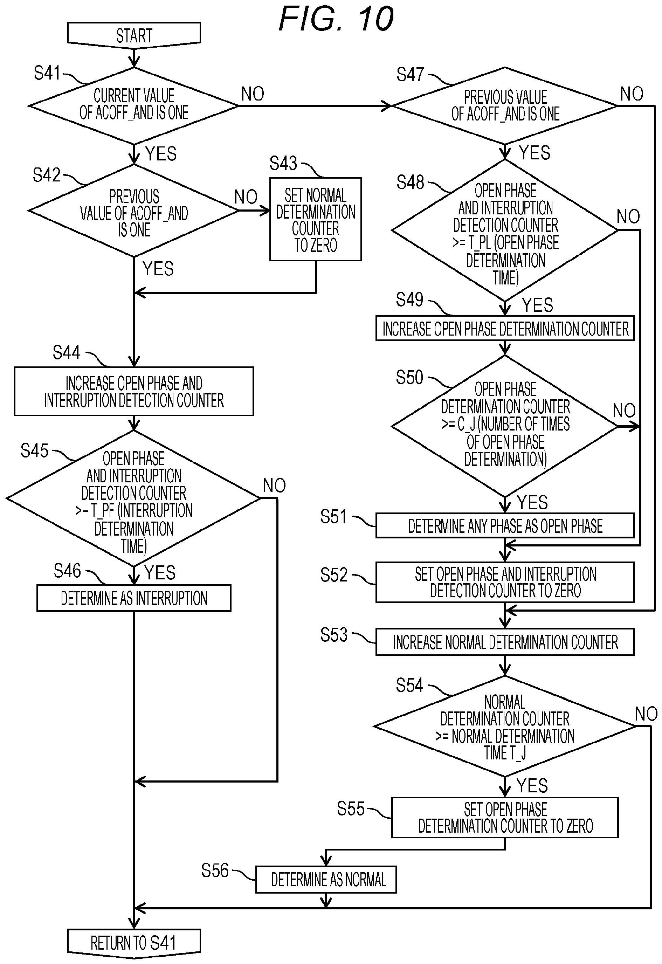

FIG. 10 is a flowchart illustrating a method for determining an open phase and interruption. The determination of the open phase and the interruption of three-phase AC power supply 1 in controller 7b will be specifically described with reference to FIG. 10. Note that controller 7b can be configured by, for example, a central processing unit (CPU). In that case, a subsequent process can be executed by, for example, a program stored in the CPU.

Although not illustrated in FIG. 10, in an initial step, preparations for a step of determining normal, open phase, and interruption are executed. In the initial step, ACOFF1 to 3 are acquired from photocouplers 14, 24, 34 or generated from the outputs of photocouplers 14, 24, 34. Furthermore, AND operations of these ACOFF1 to 3 are performed to generate ACOFF_AND.

In step S41, it is determined whether the current value of ACOFF_AND is 1. If the current value of ACCOFF_AND is 1 (YES in step S41), the process proceeds to step S42. If the current value of ACCOFF_AND is not 1 (NO in step S41), the process proceeds to step S47.

In step S42, it is determined whether the previous value of ACCOFF_AND is 1. If the previous value of ACCOFF_AND is 1 (YES in step S42), the process proceeds to step S44. By this step, it can be detected that the value of ACCOFF_AND has been switched from 1 to 0. If the previous value of ACCOFF_AND is not 1 (NO in step S42), the normal determination counter is set to 0 (step S43), and the process proceeds to step S44.

In step S44, the open phase and interruption detection counter is changed in one direction (FIGS. 7 to 9), and the process proceeds to step S45. For example, the open phase and interruption detection counter value starts from an initial value (for example, 0) and changes so as to sequentially increase every time step S44 is passed. Thus, the value of the open phase and interruption detection counter increases in proportion to the time when photocouplers 14, 24, 34 are on, and thus has a timing function. Because the open phase and interruption detection counter increases in proportion to the time during which ACCOFF_AND is maintained at 1, controller 7b can measure the time when photocouplers 14, 24, 34 are on based on the value of the open phase and interruption detection counter. Note that the initial value is not limited to 0. Further, it is not limited to the configuration in which the initial value gradually increases every time step S44 is passed, and the open phase and interruption detection counter value may start from the initial value and sequentially decrease every time step S44 is passed.

In step S45, the open phase and interruption detection counter and interruption determination time value T_PF are compared. Consequently, when it is determined that the value of the open phase and interruption detection counter is equal to or exceeds interruption determination time value T_PF (YES in step S45 in FIGS. 8 and 9), interruption is determined (step S46). When the value of the open phase and interruption detection counter has not exceeded interruption determination time value T_PF (step S45: NO), the process returns to first step S41.

In step S47, it is determined whether a previous value of ACCOFF_AND is 1. When the previous value of ACCOFF_AND is 1 (step S47: YES), the process proceeds to step S48. By this step 47, it is detected that the value of ACCOFF_AND is switched from 1 to 0. When the previous value of ACCOFF_AND is not 1 (NO in step S47), the process proceeds to step S53.

In step S48, the open phase and interruption detection counter and open phase determination time value T_PL are compared. Consequently, when the open phase and interruption detection counter is equal to or exceeds open phase determination time value T_PL (YES in step S48), the process proceeds to step S49. When the open phase and interruption detection counter is not equal to or more than open phase determination time T_PL (NO in step S48), the process proceeds to S52.

In step S49, the open phase determination counter is changed and increased in one direction (FIGS. 7 and 9), and the process proceeds to step S50. For example, the open phase determination counter starts from the initial value (0) and changes so as to sequentially increase every time step S49 is passed. Consequently, the value of the open phase determination counter increases in proportion to the time and a number of times of the open phase. Therefore, controller 7b can detect the time or the number of times of open phase based on the value of the open phase determination counter. Note that the initial value of the open phase determination counter is not limited to be started from 0, and may be started from a specified value. Further, the open phase determination counter may be changed so as to start from a specified value and sequentially decrease every time step S49 is passed.

In step S50, the open phase determination counter and open phase determination value C_J are compared. In step S50, it is determined whether the open phase determination counter is equal to or exceeds open phase determination value C_J. When it is determined that the open phase determination counter is equal to or exceeds open phase determination value C_J (YES in FIG. 7, FIG. 9, step S50), it is determined that any of the phases is open-phase (step S51). When it is determined that the open phase determination counter does not exceed open phase determination value C_J (NO in step S50), the process proceeds to step 52. Note that in step S50, the value of the open phase determination counter and open phase determination value C_J are determined as the number of times.

In step S52, the open phase and interruption detection counter is set to the initial value (0), and the process proceeds to step S53.

In step S53, the normal determination counter is changed in one direction (FIG. 9), and the process proceeds to step S54. Note that in step S53, the normal determination counter is changed in an increasing direction. For example, the normal determination counter starts from the initial value (0) and changes so as to sequentially increase every time step S53 is passed. Thus, the normal determination counter value increases in proportion to the time during which three-phase AC power supply 1 is operating normally. Therefore, controller 7b can detect that three-phase AC power supply 1 is operating normally based on the normal determination counter value. Note that the initial value of the normal determination counter is not limited to starting from 0, and may be started from a specified value. Further, the normal determination counter may be changed so as to start from the initial value and sequentially decrease every time step S49 is passed. In step S54, the normal determination counter and normal determination time value T_J are compared. When it is determined that the normal determination counter is equal to or exceeds normal determination time value T_J (YES in step S54 in FIG. 9), the open phase determination counter is returned to the initial value (step S55), it is determined to be normal (step S56), and the process returns to first step S41. If the normal determination counter does not exceed normal determination time T_J (NO in step S54), the process returns to the process of first step S41.

By repeating the processes of steps S41 to S56, it is possible to determine open phase and interruption of three-phase AC power supply 1.

Note that in the first exemplary embodiment, when it is detected that the value of ACOFF_AND is switched from 1 to 0 (NO in step S41, YES in step S47), the open phase determination process (steps S48 to S51) is performed. In this manner, it is possible to exclusively determine the open phase and the interruption of three-phase AC power supply 1 without determining the open phase at the time of interruption. On the other hand, the open phase determination process (steps S48 to S51) may be performed after step S45. It is possible to determine the open phase earlier by performing the open phase determination process (steps S48 to S51) after step S45.

As illustrated in FIG. 1, the output of controller 7b is supplied to display 9 (for example, an LED lamp). Controller 7b outputs a determination result to display 9 after determining an open phase and interruption of three-phase AC power supply 1. Consequently, display 9 informs the outside of the open phase or interrupted state, thereby improving the ease of inspection and safety.

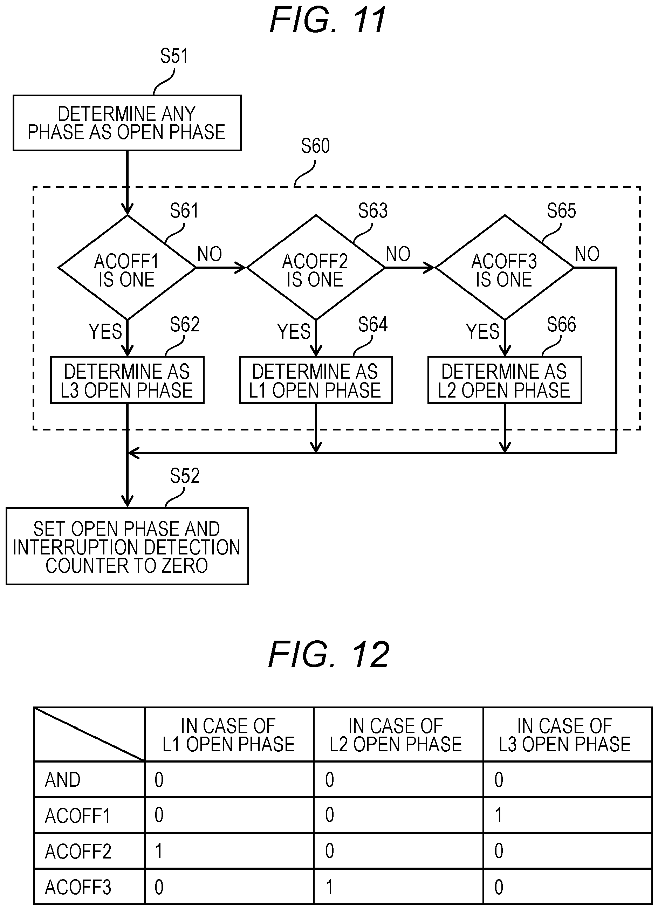

FIG. 11 is a flowchart illustrating a method for determining the open phase of the three-phase AC power supply. Step S60 is provided between step 51 and step 52 illustrated in FIG. 10 when determining which of the L1 phase to the L3 phase is open-phase. Note that the process is the same as that illustrated in FIG. 10 except that step S60 is inserted between step 51 and step 52, and thus description thereof is omitted.

FIG. 12 is a summary diagram of the determination method in step S60. As illustrated in FIG. 12, it is possible to determine that which phase of the L1 phase to the L3 phase is open-phase from the values of ACOFF1 to 3 when the AND operation pulse is 0. Accordingly, in step S60, it is determined which of the conditions illustrated in FIG. 12 the AND operation pulse and ACOFF1 to 3 match.

Because step S60 has passed the determination of step S41 illustrated in FIG. 10 (NO in step S41), the current value of ACCOFF_AND in step S60 is 0.

In step S61, it is determined whether ACCOFF1 is 1. When ACCOFF1 is 1 (YES in step S61), it is determined that the L3 phase is open-phase (step S62) (FIG. 5), and the process proceeds to step S52. When ACCOFF1 is not 1, the process proceeds to step S63.

In step S63, it is determined whether ACCOFF2 is 1. When ACCOFF2 is 1 (YES in step S63), it is determined that the L1 phase is open-phase (step S64), and the process proceeds to step S52. When ACCOFF2 is not 1, the process proceeds to step S65.

In step S65, it is determined whether ACCOFF3 is 1. When ACCOFF3 is 1 (YES in step S65), it is determined that the L2 phase is open-phase (step S66), and the process proceeds to step S52. When ACCOFF3 is not 1, the process proceeds to step S52.

In each of the determination steps in FIGS. 10 and 11, the determination condition values may be reversed between 0 and 1, and YES and NO as a result of the determination condition may be interchanged.

### (Modification Example 1)

Next, a method for determining an open phase and interruption when the voltage or frequency of three-phase AC power supply 1 changes will be described.

Interruption determination time T_B, open phase determination time T_PL, normal determination time T_J, and phase absence determination time C_J can be set in controller 7b.

When threshold voltage V_ON at which photocouplers 14, 24, 34 are turned on remains the same, and the voltage of three-phase AC power supply 1 increases, the time for the AND operation pulse to maintain 1 becomes shorter. On the contrary, when the voltage of three-phase AC power supply 1 decreases, the time for the AND operation pulse to maintain 1 becomes longer. When the frequency of three-phase AC power supply 1 increases, a number of times when the AND operation pulse is 1 increases for one cycle. When the frequency of three-phase AC power supply 1 decreases, the number of times when the AND operation pulse is 1 decreases for one cycle.

Therefore, the above-described waveforms can be obtained by adjusting the above-mentioned set values according to changes in the voltage and frequency of three-phase AC power supply 1. Therefore, the circuit element does not need to be changed in particular, and it is possible to determine open phase or interruption of three-phase AC power supply 1 for various voltages and frequencies.

### (Modification Example 2)

Photocouplers 14, 24, 34 may output low in an on state. In this case, controller 7b captures inverted values of output signals of photocouplers 14, 24, 34 as ACCOFF1 to 3. Alternatively, a NOT circuit that inverts a signal may be inserted between photocouplers 14, 24, 34 and controller 7b. In these cases, the values of ACCOFF1 to 3 are 1 when photocouplers 14, 24, 34 are in an on state. Therefore, controller 7b makes a determination according to the processes illustrated in FIGS. 4 to 12.

### (Modification Example 3)

Photocouplers 14, 24, 34 are configured to output low in an on state, and controller 7b acquires outputs of photocouplers 14, 24, 34 as they are, to thereby generate inverted ACCOFF1 to 3. Alternatively, when photocouplers 14, 24, 34 output high in an on state, a NOT circuit that inverts a signal is inserted between photocouplers 14, 24, 34 and controller 7b, or controller 7b inverts the output signals of photocouplers 14, 24, 34 to generate inverted ACCOFF1 to 3.

In this example, inverted ACCOFF1 to 3 are signals obtained by inverting ACCOFF1 to 3 illustrated in FIGS. 4 to 6. That is, when photocouplers 14, 24, 34 are in an on state, the values of inverted ACCOFF1 to 3 are 0.

Controller 7b inverts inverted ACCOFF1 to 3 and performs an AND operation to obtain ACCOFF_AND.

In this case, in the determination steps (steps S61, S63, S65) of FIG. 11 and in FIG. 12, the determination may be made by inverted ACCOFF1 to 3 instead of ACCOFF1 to 3. At this time, the value of the determination condition in these steps is replaced from 1 to 0. In FIG. 12, when ACCOFF1 to 3 are replaced with inverted ACCOFF1 to 3 for determination, the values of the determination conditions for each phase are inverted between 1 and 0. However, the value of ACCOFF_AND remains 0.

As described above, as an example of the technique disclosed in the present application, the first exemplary embodiment including the above-described modification examples has been described. However, the technique according to the present disclosure is not limited to these, and is applicable to exemplary embodiments in which changes, replacements, additions, omissions, and the like are appropriately made or modification examples other than the above ones, as long as it does not deviate from the gist of the present disclosure.

For example, in the first exemplary embodiment, the AND operation in controller 7b may be performed by using the AND circuit.

The open phase and interruption detection device for the three-phase AC power supply according to the present disclosure can be widely used in devices and the like, such as motors, that uses the three-phase AC power supply.

## Claims

1. An open phase and interruption detection device for a three-phase AC power supply (1), the device comprising:
three photocouplers (14, 24, 34) that are configured to be connected between respective lines of an L1 phase and an L2 phase, the L2 phase and an L3 phase, and the L3 phase and the L1 phase, respectively, of the three-phase AC power supply (1), each includes a light receiving element (14b, 24b, 34b) that is configured to turn on at a predetermined threshold voltage or higher, and are configured to convert line voltages of the L1 phase and the L2 phase, the L2 phase and the L3 phase, and the L3 phase and the L1 phase of the three-phase AC power supply (1) into three detection signals; and
a controller (7b) that is configured to acquire three pulse detection signals from the three detection signals output from the three photocouplers (14, 24, 34) or an inverted pulse detection signal obtained by inverting the three pulse detection signals,
wherein the controller (7b) is configured to perform an AND operation of the three pulse detection signals or is configured to invert three inverted pulse detection signals and to perform the AND operation, to generate an AND operation pulse, and is configured to determine a normal state and presence or absence of an open phase or interruption by the AND operation pulse;
**characterized in that**:
the controller (7b) includes first and second counters, and
the controller (7b)
a) is configured to change the first counter sequentially in a constant direction during a time in which a value of the AND operation pulse continues to be 0, and is configured to determine that it is a normal state when the first counter exceeds a first value that is set in advance, and
b) is configured to return the first counter to 0 when the value of the AND operation pulse is switched from 0 to 1 and is configured to sequentially change the second counter in a constant direction during a time in which the AND operation pulse continues to be 1, and is configured to determine the presence of the interruption when it is determined that the second counter is equal to or exceeds a second value that is set in advance, or is configured to determine the presence of the open phase when it is determined that the second counter is equal to or exceeds a third value smaller than the first and second values.

2. The open phase and interruption detection device for the three-phase AC power supply (1) according to claim 1, wherein when the controller (7b) determines the presence of the open phase, the controller (7b) determines which of the L1 phase, the L2 phase, and the L3 phase is the open phase based on one of the three pulse detection signals or the three inverted pulse detection signals and the AND operation pulse.

3. The open phase and interruption detection device for the three-phase AC power supply (1) according to claim 1, wherein when the value of the AND operation pulse is 0 when determining the open phase, the controller (7b) determines that the phase for which a value out of the three pulse detection signals is 1 or the phase for which a value out of the three inverted pulse detection signals is 0 as the open phase.

4. The open phase and interruption detection device for the three-phase AC power supply (1) according to claim 1, wherein the controller (7b) adjusts at least one of the first to third values according to at least one of a voltage and a frequency of the three-phase AC power supply (1).

5. A method for detecting an open phase and interruption in a three-phase AC power supply (1), the method comprising:
acquiring three pulse detection signals or three inverted pulse detection signals of three pulse detection signals from three photocouplers (14, 24, 34) connected to respective lines between lines of an L1 phase and an L2 phase, between lines of the L2 phase and an L3 phase, and between lines of the L3 phase and the L1 phase of the three-phase AC power supply that outputs an alternating current (AC) voltage in the L1 phase, the L2 phase, and the L3 phase;
performing an AND operation of the three pulse detection signals, or inverting the three inverted pulse detection signals and performing the AND operation, to generate an AND operation pulse; and
determining a normal state of the AC voltage and presence or absence of an open phase or interruption by the AND operation pulse;
**characterized in that**:
the determining of the presence or absence of the open phase or interruption includes:
a) changing a first counter sequentially in a constant direction during a time in which a value of the AND operation pulse continues to be 0, and determining that it is normal when it is determined that the first counter is equal to or exceeds a first value that is set in advance, and
b) returning the first counter to 0 when the AND operation pulse is switched from 0 to 1 and sequentially changing a second counter in a constant direction during a time in which the value of the AND operation pulse continues to be 1, and determining the presence of the interruption when the second counter is equal to or exceeds a second value that is set in advance, or determining the presence of the open phase when it is determined that the second counter is equal to or exceeds a third value smaller than the first and second values.

6. The method for detecting the open phase and interruption in the three-phase AC power supply (1) according to claim 5, wherein when the presence of the open phase of the AC voltage is determined, which of the L1 phase, the L2 phase, and the L3 phase is the open phase is determined based on each of the pulse detection signals or each of the inverted pulse detection signals and the AND operation pulse.

7. The method for detecting the open phase and interruption in the three-phase AC power supply (1) according to claim 5, wherein the determination of the open phase is executed before the determination of the interruption.

8. The method for detecting the open phase and interruption in the three-phase AC power supply (1) according to claim 5, wherein the determination of the interruption is executed before the determination of the open phase.

9. The method for detecting the open phase and interruption in the three-phase AC power supply (1) according to claim 7, wherein when the AND operation pulse is 0 in the determination of the open phase, the phase for which a value out of the three pulse detection signals is 1 or the phase for which a value out of the three inverted pulse detection signals is 0 is determined as the open phase.

10. The method for detecting the open phase and interruption in the three-phase AC power supply (1) according to claim 7, wherein
at least one of the first to third values is set in a controller (7b), and
at least one of the first to third values that are set is adjusted according to at least one of a voltage or a frequency of the three-phase AC power supply (1).

## Patentansprüche

1. Vorrichtung zur Erkennung von offenen Phasen und Unterbrechungen für eine dreiphasige Wechselstromversorgung (1), wobei die Vorrichtung Folgendes umfasst:
drei Optokoppler (14, 24, 34), die konfiguriert sind, um zwischen den jeweiligen Leitungen einer L1-Phase und einer L2-Phase, der L2-Phase und einer L3-Phase sowie der L3-Phase bzw. der L1-Phase der dreiphasigen Wechselstromversorgung (1) geschalten zu werden, jeweils ein Lichtempfangselement (14b, 24b, 34b) aufweisen, das konfiguriert ist, um sich bei einer vorbestimmten Schwellenspannung oder höher einzuschalten, und die konfiguriert sind, um Netzspannungen der L1-Phase und der L2-Phase, der L2-Phase und der L3-Phase sowie der L3-Phase und der L1-Phase der dreiphasigen Wechselstromversorgung (1) in drei Detektionssignale umzuwandeln; und
eine Steuerung (7b), die konfiguriert ist, um aus den drei von den drei Optokopplern (14, 24, 34) ausgegebenen Pulsdetektionssignalen drei Impulsdetektionssignale oder ein invertiertes Impulsdetektionssignal zu erfassen, das durch Invertieren der drei Impulsdetektionssignale erhalten wird,
wobei die Steuerung (7b) konfiguriert ist, um eine UND-Operation der drei Impulsdetektionssignale auszuführen oder konfiguriert ist, um drei invertierte Impulsdetektionssignale zu invertieren und die UND-Operation auszuführen, um einen UND-Operationsimpuls zu erzeugen, und konfiguriert ist, um einen Normalzustand und das Vorhandensein oder Fehlen einer offenen Phase oder Unterbrechung durch den UND-Operationsimpuls festzustellen;
**dadurch gekennzeichnet, dass**:
die Steuerung (7b) erste und zweite Zähler aufweist und
die Steuerung (7b)
a) konfiguriert ist, um den ersten Zähler sequentiell in einer konstanten Richtung während einer Zeit zu ändern, in der ein Wert des UND-Operationsimpulses weiterhin 0 ist, und konfiguriert ist, um festzustellen, dass es sich um einen Normalzustand handelt, wenn der erste Zähler einen im Voraus eingestellten ersten Wert überschreitet, und
b) konfiguriert ist, um den ersten Zähler auf 0 zurückzusetzen, wenn der Wert des UND-Operationsimpulses von 0 auf 1 umgeschaltet wird, und konfiguriert ist, um den zweiten Zähler sequentiell in einer konstanten Richtung während einer Zeit, in der der UND-Operationsimpuls weiterhin 1 ist, zu ändern, konfiguriert ist, um das Vorhandensein der Unterbrechung festzustellen, wenn festgestellt wird, dass der zweite Zähler gleich ist wie oder größer ist als ein zweiter Wert, der im Voraus festgelegt wurde, oder konfiguriert ist, um das Vorhandensein der offenen Phase festzustellen, wenn festgestellt wird, dass der zweite Zähler gleich ist wie oder größer ist als ein dritter Wert, der kleiner als der erste und der zweite Wert ist.

2. Vorrichtung zur Erkennung von offenen Phasen und Unterbrechungen für die dreiphasige Wechselstromversorgung (1) nach Anspruch 1, wobei, wenn die Steuerung (7b) das Vorhandensein der offenen Phase bestimmt, die Steuerung (7b) bestimmt, welche aus der L1-Phase, der L2-Phase und der L3-Phase die offene Phase ist, basierend auf einem der drei Impulsdetektionssignale oder den drei invertierten Impulsdetektionssignalen und dem UND-Operationsimpuls.

3. Vorrichtung zur Erkennung von offenen Phasen und Unterbrechungen für die dreiphasige Wechselstromversorgung (1) nach Anspruch 1, wobei, wenn der Wert des UND-Operationsimpulses 0 ist, wenn die offene Phase bestimmt wird, die Steuerung (7b) bestimmt, dass die Phase, für die ein Wert aus den drei Impulsdetektionssignalen 1 ist, oder die Phase, für die ein Wert aus den drei invertierten Impulsdetektionssignalen 0 ist, die offene Phase ist.

4. Vorrichtung zur Erkennung von offenen Phasen und Unterbrechungen für die dreiphasige Wechselstromversorgung (1) nach Anspruch 1, wobei die Steuerung (7b) mindestens einen der ersten bis dritten Werte entsprechend einer Spannung und/oder einer Frequenz der dreiphasigen Wechselstromversorgung (1) einstellt.

5. Verfahren zum Erkennen einer offenen Phase und einer Unterbrechung in einer dreiphasigen Wechselstromversorgung (1), wobei das Verfahren umfasst:
Erfassung von drei Impulsdetektionssignalen oder drei invertierten Impulsdetektionssignalen von drei Impulsdetektionssignalen von drei Optokopplern (14, 24, 34), die mit entsprechenden Leitungen zwischen Leitungen einer L1-Phase und einer L2-Phase, zwischen Leitungen der L2-Phase und einer L3-Phase und zwischen Leitungen der L3-Phase und der L1-Phase der dreiphasigen Wechselstromversorgung verbunden sind, die eine Wechselstromspannung (AC) in der L1-Phase, der L2-Phase, und der L3-Phase ausgibt;
Ausführen einer UND-Operation der drei Impulsdetektionssignale oder Invertieren der drei invertierten Impulsdetektionssignale und Ausführen der UND-Operation, um einen UND-Operationssimpuls zu erzeugen; und
Feststellung eines Normalzustands der Wechselspannung und des Vorhandenseins oder Nichtvorhandenseins einer offenen Phase oder Unterbrechung durch den UND-Operationsimpuls;
**dadurch gekennzeichnet, dass**:
die Feststellung des Vorhandenseins oder Nichtvorhandenseins der offenen Phase oder Unterbrechung umfasst:
a) sequentielles Ändern eines ersten Zählers in einer konstanten Richtung während einer Zeit, in der ein Wert des UND-Operationsimpulses weiterhin 0 ist, und Bestimmen, dass es normal ist, wenn festgestellt wird, dass der erste Zähler gleich wie oder größer als ein im Voraus eingestellter erster Wert ist, und
b) Zurücksetzen des ersten Zählers auf 0, wenn der UND-Operationsimpuls von 0 auf 1 umgeschaltet wird, und sequentielles Ändern eines zweiten Zählers in einer konstanten Richtung während einer Zeit, in der der Wert des UND-Operationsimpulses weiterhin 1 ist, und Bestimmen des Vorhandenseins der Unterbrechung, wenn der zweite Zähler gleich oder größer als ein im Voraus eingestellter zweiter Wert ist, oder Bestimmen des Vorhandenseins der offenen Phase, wenn festgestellt wird, dass der zweite Zähler gleich einem oder größer als ein dritter Wert ist, der kleiner als der erste und der zweite Wert ist.

6. Verfahren zum Erfassen der offenen Phase und der Unterbrechung in der dreiphasigen Wechselstromversorgung (1) nach Anspruch 5, wobei, wenn das Vorhandensein der offenen Phase der Wechselspannung bestimmt wird, basierend auf jedem der Impulsdetektionssignale oder jedes der invertierten Impulsdetektionssignale und des UND-Operationsimpulses bestimmt wird, welche der L1-Phase, der L2-Phase und der L3-Phase die offene Phase ist,.

7. Verfahren zum Erfassen der offenen Phase und der Unterbrechung in der dreiphasigen Wechselstromversorgung (1) nach Anspruch 5, wobei die Bestimmung der offenen Phase vor der Bestimmung der Unterbrechung durchgeführt wird.

8. Verfahren zum Erfassen der offenen Phase und der Unterbrechung in der dreiphasigen Wechselstromversorgung (1) nach Anspruch 5, wobei die Bestimmung der Unterbrechung vor der Bestimmung der offenen Phase erfolgt.

9. Verfahren zum Erfassen der offenen Phase und der Unterbrechung in der dreiphasigen Wechselstromversorgung (1) nach Anspruch 7, wobei, wenn der UND-Operationsimpuls bei der Bestimmung der offenen Phase 0 ist, die Phase, für die ein Wert aus den drei Impulsdetektionssignalen 1 ist, oder die Phase, für die ein Wert aus den drei invertierten Impulsdetektionssignalen 0 ist, als offene Phase bestimmt wird.

10. Verfahren zum Erfassen der offenen Phase und der Unterbrechung in der dreiphasigen Wechselstromversorgung (1) nach Anspruch 7, wobei
mindestens einer der ersten bis dritten Werte in einer Steuerung (7b) festgelegt ist und
mindestens einer der ersten bis dritten Werte, die eingestellt werden, entsprechend mindestens einer Spannung oder einer Frequenz der dreiphasigen Wechselstromversorgung (1) eingestellt wird.

## Revendications

1. Dispositif de détection de phase ouverte et d'interruption pour une alimentation électrique CA triphasée (1), le dispositif comprenant :
trois photocoupleurs (14, 24, 34) qui sont configurés pour être connectés entre des lignes respectives d'une phase L1 et d'une phase L2, de la phase L2 et d'une phase L3, et de la phase L3 et de la phase L1, respectivement, de l'alimentation électrique CA triphasée (1), chacun inclut un élément de réception de lumière (14b, 24b, 34b) qui est configuré pour s'allumer à une tension seuil prédéterminée ou plus, et sont configurés pour convertir des tensions de ligne de la phase L1 et de la phase L2, de la phase L2 et de la phase L3, et de la phase L3 et de la phase L1 de l'alimentation électrique CA triphasée (1) en trois signaux de détection ; et
un organe de commande (7b) qui est configuré pour acquérir trois signaux de détection d'impulsion à partir des trois signaux de détection sortis des trois photocoupleurs (14, 24, 34) ou un signal de détection d'impulsion inversé obtenu en inversant les trois signaux de détection d'impulsion,
dans lequel l'organe de commande (7b) est configuré pour réaliser une opération ET des trois signaux de détection d'impulsion ou est configuré pour inverser trois signaux de détection d'impulsion inversés et pour réaliser l'opération ET, pour générer une impulsion d'opération ET, et est configuré pour déterminer un état normal et une présence ou absence d'une phase ouverte ou d'une interruption par l'intermédiaire de l'impulsion d'opération ET ;
**caractérisé en ce que** :
l'organe de commande (7b) inclut des premier et second compteurs, et
l'organe de commande (7b)
a) est configuré pour changer le premier compteur séquentiellement dans une direction constante durant un temps pendant lequel une valeur de l'impulsion d'opération ET continue d'être 0, et est configuré pour déterminer qu'il existe un état normal lorsque le premier compteur dépasse une première valeur qui est réglée d'avance, et
b) est configuré pour remettre le premier compteur à 0 lorsque la valeur de l'impulsion d'opération ET est permutée de 0 à 1 et est configuré pour séquentiellement changer le second compteur dans une direction constante durant un temps pendant lequel l'impulsion d'opération ET continue d'être 1, et est configuré pour déterminer la présence de l'interruption lorsqu'il est déterminé que le second compteur est égal à ou dépasse une deuxième valeur qui est réglée d'avance, ou est configuré pour déterminer la présence de la phase ouverte lorsqu'il est déterminé que le second compteur est égal à ou dépasse une troisième valeur plus petite que les première et deuxième valeurs.

2. Dispositif de détection de phase ouverte et d'interruption pour l'alimentation électrique CA triphasée (1) selon la revendication 1, dans lequel, lorsque l'organe de commande (7b) détermine la présence de la phase ouverte, l'organe de commande (7b) détermine celle de la phase L1, de la phase L2, et de la phase L3 qui est la phase ouverte sur la base d'un des trois signaux de détection d'impulsion ou des trois signaux de détection d'impulsion inversés et de l'impulsion d'opération ET.

3. Dispositif de détection de phase ouverte et d'interruption pour l'alimentation électrique CA triphasée (1) selon la revendication 1, dans lequel, lorsque la valeur de l'impulsion d'opération ET est 0 lors de la détermination de la phase ouverte, l'organe de commande (7b) détermine que la phase pour laquelle une valeur parmi les trois signaux de détection d'impulsion est 1 ou la phase pour laquelle une valeur parmi les trois signaux de détection d'impulsion inversés est 0 comme étant la phase ouverte.

4. Dispositif de détection de phase ouverte et d'interruption pour l'alimentation électrique CA triphasée (1) selon la revendication 1, dans lequel l'organe de commande (7b) ajuste au moins une des valeurs, de la première à la troisième, selon au moins une d'une tension et d'une fréquence de l'alimentation électrique CA triphasée (1).

5. Procédé pour détecter une phase ouverte et une interruption dans une alimentation électrique CA triphasée (1), le procédé comprenant :
l'acquisition de trois signaux de détection d'impulsion ou de trois signaux de détection d'impulsion inversés de trois signaux de détection d'impulsion à partir de trois photocoupleurs (14, 24, 34) connectés à des lignes respectives entre des lignes d'une phase L1 et d'une phase L2, entre des lignes de la phase L2 et d'une phase L3, et entre des lignes de la phase L3 et de la phase L1 de l'alimentation électrique CA triphasée qui sort une tension à courant alternatif (CA) dans la phase L1, la phase L2, et la phase L3 ;
la réalisation d'une opération ET des trois signaux de détection d'impulsion, ou l'inversion des trois signaux de détection d'impulsion inversés et la réalisation de l'opération ET, pour générer une impulsion d'opération ET ; et
la détermination d'un état normal de la tension CA et d'une présence ou d'une absence d'une phase ouverte ou d'une interruption par l'intermédiaire de l'impulsion d'opération ET ;
**caractérisé en ce que** :
la détermination de la présence ou de l'absence de la phase ouverte ou de l'interruption inclut :
a) le changement d'un premier compteur séquentiellement dans une direction constante durant un temps pendant lequel une valeur de l'impulsion d'opération ET continue d'être 0, et la détermination que ceci est normal lorsqu'il est déterminé que le premier compteur est égal à ou dépasse une première valeur qui est réglée d'avance, et
b) la remise du premier compteur à 0 lorsque l'impulsion d'opération ET est permutée de 0 à 1 et, séquentiellement, le changement d'un second compteur dans une direction constante durant un temps pendant lequel la valeur de l'impulsion d'opération ET continue d'être 1, et la détermination de la présence de l'interruption lorsque le second compteur est égal à ou dépasse une deuxième valeur qui est réglée d'avance, ou la détermination de la présence de la phase ouverte lorsqu'il est déterminé que le second compteur est égal à ou dépasse une troisième valeur plus petite que les premier et deuxième valeurs.

6. Procédé pour détecter la phase ouverte et l'interruption dans l'alimentation électrique CA triphasée (1) selon la revendication 5, dans lequel, lorsque la présence de la phase ouverte de la tension CA est déterminée, celle de la phase L1, de la phase L2, et de la phase L3 qui est la phase ouverte est déterminée sur la base de chacun des signaux de détection d'impulsion ou de chacun des signaux de détection d'impulsion inversés et de l'impulsion d'opération ET.

7. Procédé pour détecter la phase ouverte et l'interruption dans l'alimentation électrique CA triphasée (1) selon la revendication 5, dans lequel la détermination de la phase ouverte est exécutée avant la détermination de l'interruption.

8. Procédé pour détecter la phase ouverte et l'interruption dans l'alimentation électrique CA triphasée (1) selon la revendication 5, dans lequel la détermination de l'interruption est exécutée avant la détermination de la phase ouverte.

9. Procédé pour détecter la phase ouverte et l'interruption dans l'alimentation électrique CA triphasée (1) selon la revendication 7, dans lequel, lorsque l'impulsion d'opération ET est 0 dans la détermination de la phase ouverte, la phase pour laquelle une valeur parmi les trois signaux de détection d'impulsion est 1 ou la phase pour laquelle une valeur parmi les trois signaux de détection d'impulsion inversés est 0 est déterminée comme étant la phase ouverte.

10. Procédé pour détecter la phase ouverte et interruption dans l'alimentation électrique CA triphasée (1) selon la revendication 7, dans lequel
au moins une des valeurs, de la première à la troisième, est réglée dans un organe de commande (7b), et
au moins une des valeurs, de la première à la troisième, qui sont réglées est ajustée selon au moins une d'une tension ou d'une fréquence de l'alimentation électrique CA triphasée (1).
